# EUROPÄISCHE PATENTSCHRIFT

(11) **EP 3 283 664 B1**
(45) Veröffentlichungstag und Bekanntmachung des Hinweises auf die Patenterteilung: **29.01.2020**
(21) Anmeldenummer: 16759683.2
(22) Anmeldetag: 04.04.2016
(51) Int. Cl.: C23C 14/00, C23C 14/32

(54) **BIPOLARES ARC-BESCHICHTUNGSVERFAHREN**
BIPOLAR ARC COATING METHOD
PROCÉDÉ DE REVÊTEMENT À L'ARC BIPOLAIRE

(30) Priorität: 15.04.2015 DE 102015004856
(43) Veröffentlichungstag der Anmeldung: 21.02.2018
(73) Patentinhaber: Oerlikon Surface Solutions AG, Pfäffikon, 8808 Pfäffikon (CH)
(72) Erfinder: VETTER, Joerg, 51429 Bergisch Gladbach (DE)
(74) Vertreter: Misselhorn, Hein-Martin
(86) Internationale Anmeldenummer: PCT/EP2016/057352
(87) Internationale Veröffentlichungsnummer: WO 2016/184596

(56) Entgegenhaltungen:
- US-A- 5 103 766

## Beschreibung

Beim Arcverdampfen, oder auch Lichtbogenverdampfen genannt, wird fortals Materiallieferant ein leitender Festkörper eingesetzt. Dieses sogenannte Target wird als Kathode betrieben, d.h. es wird im Vergleich zu einer Anodenfläche eine negative Spannung angelegt. Kathode und Anode sind in einer Beschichtungskammer angeordnet. Für den Beschichtungsprozess wird die Beschichtungskammer evakuiert. Anschliessend werden aus der Kathode Elektronen in Form eines Lichtbogens (im Weiteren auch Arc oder Funken genannt) herausgezogen. Die Elektronen wandern im Wesentlichen zur Anodenfläche. Die Zündung des Lichtbogens kann auf unterschiedliche Art und Weise stattfinden. Beispielsweise kann hierzu ein dem Fachmann bekannter Zündfinger eingesetzt werden. An der Stelle, an der die Elektronen dem Target entzogen werden, am sogenannten Elektronenfleck, kommt es zu einem erheblichen Energieeintrag, der bewirkt, dass das Targetmaterial in die Dampfphase übergeht. Während des Verfahrens wird mit unterschiedlichen Mitteln darauf geachtet, dass dieser Fleck möglichst keine Stelle der Targetoberfläche bevorzugt, sondern beständig auf dieser umhertanzt. Dies kann beispielsweise mit geeigneten Magnetfeldern erreicht werden.

Das verdampfte Material ist zu einem sehr hohen Prozentsatz ionisiert, sodass es sich beispielsweise mit einem an zu beschichtenden Substraten angelegten negativen Bias auf diese Substrate hin beschleunigen lässt. Dies führt zu einer Beschichtung der Substrate, wobei die Dichte der Schicht eine sehr hohe sein kann. Ein solches Verfahren wird auch Arcverdampfen oder Lichtbogenverdampfen genannt. Ein mit dem Arcverdampfen einhergehendes Phänomen sind die sogenannten Spritzer. Dies sind aufgrund des plötzlichen Energieeintrags an der Targetoberfläche sich spontan ablösende grössere, aufgeschmolzene Materialmengen. Wenn diese sich auf den zu beschichtenden Substraten ablegen, so führt dies zu einer beträchtlichen Rauheit der Beschichtung.

Das Arcverdampfen wird auch häufig als reaktiver Prozess betrieben. Dabei wird in die Kammer ein sogenanntes Reaktivgas, wie beispielsweise Stickstoff oder Sauerstoff eingeleitet. Auf ihrem Weg zu den zu beschichtenden Substraten reagieren dann die Ionen mit dem Reaktivgas, sodass sich eine Verbindung auf den Substraten ablegt.

Teilweise reagiert dieses Reaktivgas aber bereits mit der Targetoberfläche selbst. Dies ist dann im Wesentlichen nicht problematisch, wenn die entstehende Verbindung wiederum ein elektrisch leitfähiges Material bildet.

Problematisch wird es allerdings dann, wenn die entstehende Verbindung ein elektrisch isolierendes Material bildet und die sich auf dem Target bildende isolierende Schicht zu dick wird, sodass dem Target keine Elektronen mehr entzogen werden können. In solchen Fällen spricht der Fachmann von einer Vergiftung der Targetoberfläche, die zur Folge hat, dass der Beschichtungsprozess zunächst instabil wird. Insbesondere besteht die Gefahr, dass sich der Elektronenfleck an einer Stelle des Targets festfrisst und dort lokal zu erheblichem und dauerhaftem Materialabtrag führt, sodass das Target im wahrsten Sinne des Wortes ein Loch bekommt.

Die US 5,103,766 A zeigt ein Lichtbogenverdampfungsverfahren mit zwei Targets, wobei die beiden Targets abwechselnd als Anode und Kathode geschaltet werden. Die Stromversorgung erfolgt über eine DC-Stromversorgung, wodurch die oben beschriebene Problematik der Bildung einer isolierenden Schicht auf dem Target fortbesteht, wodurch das Target vergiftet werden kann. Es gibt unterschiedliche Massnahmen gegen eine solche Targetvergiftung. Beispielsweise haben Ramm et al in WO06/099760 festgestellt, dass der einer Gleichspannung überlagerte gepulste Betrieb eine solche Targetvergiftung weitgehend verhindert.

Das Pulsen von Arcquellen ist aus dem Stand der Technik schon länger bekannt, so beispielsweise beschreibt WO02/070776 sehr allgemein das Pulsen von Funkenquellen, um verschiedene Superhartschichten u. a. TiSiN abzuscheiden.

In WO03/057939 ist eine Funkenquelle beschrieben, bei der das Zünden des Funkens über eine gepulste Hochspannungsversorgung, die Speisung des Funkens über eine gepulste Hochstromversorgung erfolgt. Der Betrieb des Funkens erfolgt hier diskontinuierlich. Ausgangsmaterialien sind metallisch leitende Kathoden, leitfähige Legierungen und zusätzlich Kohlenstoff, beziehungsweise verdampfbare Halbleiter. Die hier gezeigte Arcquelle ist jedoch auf Grund der sehr komplexen Geometrie des Targetkörpers, besonders für schwer zu bearbeitende Kathodenmaterialien aufwändig zu fertigen und teuer im Betrieb.

In US6361663 wird eine Arcquelle mit einer Kathode aus elektrisch leitfähigem Material beschrieben, die gepulst bzw. moduliert gepulst mit Spitzenströmen von bis zu 5 kA und einem Basisstrom von beispielsweise 100 A betrieben wird. Auch diese Quelle ist auf Grund ihrer Bauweise mit magnetischem Tunnel und einer von der Kathode vollständig umgebenen Anode aufwändig zu fertigen und teuer im Betrieb.

Dem gesamten Stand der Technik gemeinsam ist jedoch die Problematik, dass bei der reaktiven Abscheidung, welche zu elektrisch isolierenden Materialien führt, die Anode ebenfalls beschichtet wird und diese dadurch mit der Zeit ebenfalls eine elektrisch isolierende Oberfläche bildet. Hierdurch wird der Beschichtungsprozess wiederum instabil.

Eine im Stand der Technik bekannte Gegenmassnahme ist es, die Oberfläche einer Heizwendel zur Anode zu machen. Dann kann durch rasches zyklisches Aufheizen erreicht werden, dass zumindest Teile der sich auf der Anode, d.h. der Heizwendel abgelagerten isolierenden Materialien von dieser abplatzen und somit die elektrisch leitende Oberfläche freigeben. Dieser Prozess ist allerdings selten vollständig, sodass im Wesentlichen eine nicht reproduzierbare Anodenoberfläche vorliegt.

Es besteht daher ein Bedürfnis, ein Verfahren anzugeben, bei dem es nicht zu einer dauerhaften Isolationsbelegung der Anodenoberfläche während des Beschichtungsprozesses kommt.

Erfindungsgemäss wird die Aufgabe durch die in den Patentansprüchen angegebenen Lichtbogenverdampfungsverfahren gelöst.Für den Beschichtungsprozess zumindest zwei Targets vorgesehen. Während der Beschichtung wird dann abwechselnd eines der Targets als materialliefernde Kathode und das andere Target als Anode geschaltet. Vorzugsweise erfolgt die Umschaltung so schnell, dass das sich während der Beschichtung aufbauende Plasma nicht erlischt und der über der aktuellen Kathode aufzubauende Lichtbogen sich in einfacher Weise bilden kann. Es wird erfindungsgemäss durch zumindest zwei aktive Verbrauchstargets, die abwechselnd als Anode und Kathode geschaltet sind, vermieden, dass es zu einem Anodenverlust kommt. Der Beschichtungsprozess wird somit stabilisiert.

Bei dem erfindungsgemässen Verfahren ist klar, dass sich, während ein Target als Anode geschaltet ist, auf dessen Oberfläche Beschichtungsmaterial, d.h. sich gegebenenfalls eine elektrisch isolierende Schicht bildet. Daher sollte darauf geachtet werden, dass der Wechsel von Anode zu Kathode häufig genug erfolgt, um diese elektrisch isolierende Schicht nicht zu dick werden zu lassen. Erstaunlicherweise hat sich gezeigt, dass eine sehr dünne isolierende Schicht auf der Targetoberfläche für den Beschichtungsprozess förderlich ist. Insbesondere scheint der Elektrodenfleck tendenziell eher zu Stellen zu wandern, an denen bereits eine sehr dünne isolierende Schicht vorliegt. Dies ist einem gleichmässigen Abtragen der Targetoberfläche zuträglich.

Als Betriebsweisen kommen u.a. DC, DC gepulst min/max, Hochstrompulsung und auch die Überlagerung von mehreren Pulsquellen in Frage.

Als Targets können zylinderförmige, rechteckige, kreisförmige oder sonstige geeignete Geometrien gewählt werden.

Zur Zündung des/der Lichtbogen sind beispielsweise mechanische Trigger, Triggerelektroden oder die Unterstützung durch Laser denkbar.

Als Prozessgase können neben den bekannten Arbeitsgasen Argon, Helium und dergleichen vor allem die bekannten Reaktivgase wie etwa Sauerstoff, Stickstoff und Azetylen verwendet werden. Es sind aber auch alle anderen sauerstoff-, stickstoff-und kohlenstoffhaltigen Gase, oder auch siliziumhaltige Gase wie z.B. Silane denkbar.

Im Folgenden wird anhand von Abbildungen und Beschreibungen die Erfindung näher erläutert, wobei die dargestellten Ausführungsformen beispielhaft anzusehen sind und keinerlei einschränkenden Charakter haben sollen:
Abbildung 1: Schematische Darstellung für Umschaltung der bipolaren Betriebsweise von Arcquellen mit geeigneten Schaltschützen oder Halbleiterschaltern.
Abbildung 2: Prozessschema für den bipolaren Betrieb von Arcquellen.
Abbildung 3: Schematische Darstellung für Umschaltung des bipolaren Betriebs von Arcquellen in einer weiteren Ausführungsform mit geeigneten Schaltschützen oder Halbleiterschaltern.
Abbildung 4: Schematische Darstellung für Umschaltung des bipolaren Betriebs von Arcquellen in einer weiteren Ausführungsform mit geeigneten Schaltschützen oder Halbleiterschaltern, sowie zusätzlichem bipolarem Pulskonverter.

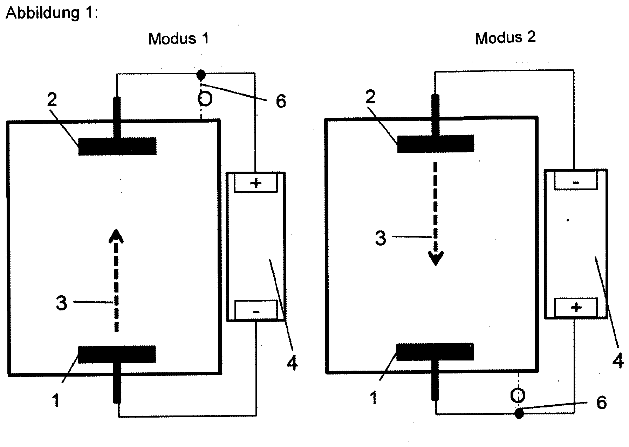

Folgende Tabelle stellt die in den Abbildungen 1 bis 4 verwendeten Begriffe zusammen:

| Nr.: | | Bezeichnung in Beschreibung |
|---|---|---|
| | | (Deutsch) |
| 1 | | Arcverdampfer 1 mit Targetmaterial A |
| 2 | | Arcverdampfer 2 mit Targetmaterial A oder B |
| 3 | | Elektronenfluss |
| 4 | | DC Stromgenerator |
| 5 | | Bipolarer Puls Konverter |
| 6 | | Anodenschalter für Kammer und/oder Hilfsanode |
| | | |
| - | | Betriebsart 1, 2 |
| - | | Umschalten als Kathode. Zünden Arcverdampfer 1 |
| - | | Umschalten als Kathode. Zünden Arcverdampfer 2 |
| - | | t_{off}, Umschaltpause |
| - | | Spannung |
| - | | Anodenstrom |
| - | | Kathodenstrom |

In Abbildung 1 ist eine Anordnung von gegenüber angeordneten Arcverdampfern 1 und 2 schematisch dargestellt, welche den sich ergebenden Elektronenfluss 3 von der Kathode zur Anode zeigt. In der linken Bildhälfte wird die Betriebsweise bzw. Mode 1 mit Arcverdampfer 1 als materialliefernder Kathode und Arcverdampfer 2 als Anode geschaltet dargestellt und in der rechten Bildhälfte in umgekehrter Betriebsart, demnach Mode 2, mit Arcverdampfer 2 als materialliefernder Kathode und Arcverdampfer 1 als Anode geschaltet. Die Stromversorgung erfolgt in beiden Betriebsarten über einen DC Stromgenerator 4.

In einer bevorzugten Ausführungsform kann die Stromversorgung der Kathode in der jeweiligen Betriebsart, wie oben beschrieben auch in den jeweiligen Zeiträumen t₁ bis tₙ als unipolar gepulste DC Stromversorgung mit einem minimialen und einem maximalen Strom oder sogar Hochstrompulsung mit unterschiedlichen Amplituden für die unterschiedlichen Zeiträume erfolgen.

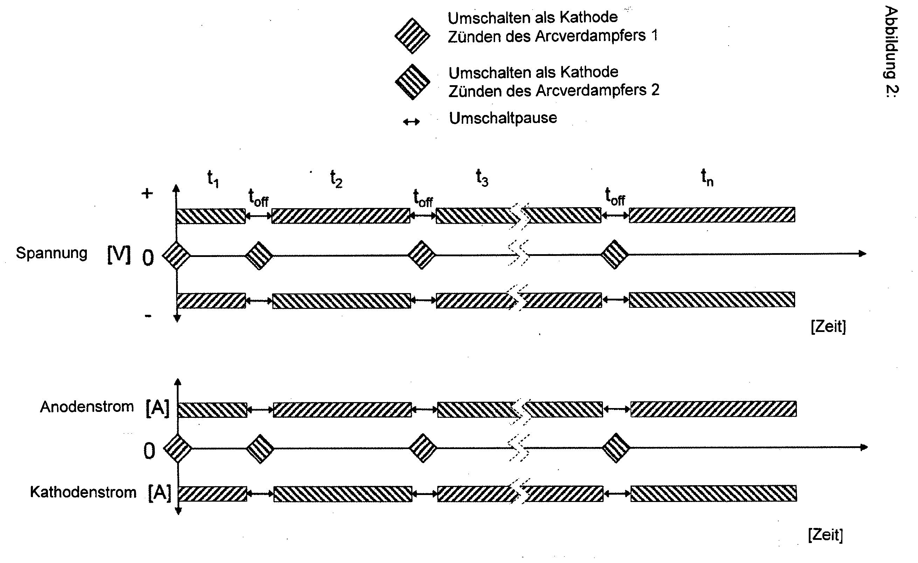

Eine Betriebsweise des erfindungsgemäßen Verfahrens ist in Abbildung 2 sinnbildlich dargestellt. Hierbei ist eine mögliche Abfolge der Spannungen und korrespondierenden, gemessenen Ströme an zwei Arcverdampfern, welche für einen gewissen Zeitraum t₁ bis tₙ wechselweise als Kathode bzw. Anode geschaltet werden, über mehrere Umschaltvorgänge illustriert. Die beispielhaft angegebenen Zeiträume t₁ bis tₙ können sich in ihrer Dauer gleichen oder voneinander unterscheiden. Die Dauer in einer Betriebsart, oder auch Mode genannt, muss jedoch für die jeweils als Kathode bzw. Anode geschaltete Arcquelle gleich lang sein. Die Änderung der Betriebsweise eines Arcverdampfers von Kathode zu Anode, oder umgekehrt, ist als Umschaltvorgang über einen Zeitraum t_{0ff} angedeutet, wobei während dieses Umschaltvorganges allfällig erforderliche Zündvorgänge der Kathode erfolgen können.

Als weitere Ausführungsform sei hierbei die Möglichkeit erwähnt, eine beliebige Abfolge von Zeiträumen für eine Betriebsart zu wählen, die sich jedoch über die Gesamtbeschichtungsdauer, t_{ges}, periodisch wiederholen. Beispielsweise kann eine Abfolge von t₁ - t₂ - t₃, mit der Bedingung t₁ <t₂<t₃, sich fortlaufend wiederholen.

Weiters ist in Abbildung 2 schematisch dargestellt, dass die negative Brennspannung des als materialliefernde Kathode geschalteten Arcverdampfers 1 einen korrespondierenden Kathodenstrom über den Zeitraum t₁ abgibt. Im gleichen Zeitraum ist umgekehrt eine positive Spannung an dem als Anode geschalteten Arcverdampfer 2 bzw. ein korrespondierender Anodenstrom zu messen. Die Absolutwerte der Spannungen an Kathode und Anode müssen naturgemäß nicht identisch und mit umgekehrtem Vorzeichen sein. Gleiches gilt für die Stromwerte an Kathode bzw. Anode.

Als besondere Ausführungsform sei angeführt, dass die gewählten Beschichtungseinstellungen, wie z.B. Kathodenstrom und/oder Biasspannung, für die beliebigen Zeiträume t₁ bis tₙ unterschiedlich sein können und damit die Höhe der jeweiligen Spannungen und Ströme an den Kathoden bzw. Anoden ebenso für die jeweiligen Zeiträume t₁ bis tₙ unterschiedlich sein können.

Der vorliegenden Erfindung ist außerdem noch inhärent, dass die zumindest zwei verwendeten Arcverdampfer mit Targetmaterialien ausgestattet sind, welche identisch oder auch unterschiedlich sein können. Die verwendeten Targetmaterialien können hierbei insbesondere ein oder mehrere Elemente in Form von Reinelementen, Legierungen oder auch geordneten Phasen, wie etwa stoichiometrische Verbindungen aufweisen. Das bedeutet, dass ein oder mehrere Targets aus jeweils einem oder mehreren Metallen, Metalllegierungen, intermetallischen Phasen und dergleichen, wie auch äquivalent dazu Metall-Nichtmetallverbindungen oder Metall-Nichtmetallverbunde, oder äquivalent dazu einem oder mehreren Nichtmetallen, deren Verbindungen oder einem Verbund derer, zusammengesetzt sein können. Damit verbunden ist die Tatsache, dass die zwei oder mehreren Arcverdampfer in Abhängigkeit ihrer Targetmaterialien mit unterschiedlichen Arcströmen betrieben werden können.

Für die erfindungsgemäße bipolare Betriebsweise der zumindest zwei Arcverdampfer in kathodischem bzw. anodischem Betrieb seien folgende Bemerkungen zu den Betriebszeiten in der jeweiligen Betriebsart angemerkt.

Besonders bei reaktiven Arcprozessen ist die Funkenbewegung am Target von vorherrschender Bedeutung, welche allerdings durch eine Reihe von Faktoren beeinflusst wird. Es seien an dieser Stelle u. a. die Wahl und Menge der Reaktivgase, der Prozessdruck bzw. die Partialdrücke, die Art und Eigenschaften des verwendeten Targetmaterials, das verwendete Magnetsystem des Arcverdampfers, die Höhe des DC- oder gepulsten Targetstroms, sowie insbesondere die Targetform und -große, als mögliche Einflussgrößen beispielhaft erwähnt.

Die Wahl einer zeitlichen Untergrenze für ein beliebiges Zeitintervall einer Betriebsart t₁ bis tₙ hängt daher stark von den oben genannten Faktoren ab und kann daher im Wesentlichen dadurch verstanden werden, dass der Funken an der Targetoberfläche eines Arcverdampfers im kathodischen Betrieb einmal die Targetoberfläche überlaufen hat.

Bei optimaler Prozessgestaltung kann durch eine Art Selbstreinigungseffekt der Targetoberfläche, also einer Entfernung der sich in reaktiver Atmosphäre ausbildenden isolierenden Bestandteile, der Prozess stabil gehalten werden. Die bestehende Problematik, einen stabilen Prozess bei der Abscheidung isolierender Schichten auszuführen, liegt jedoch darin, dass sich während des Beschichtungsprozesses die isolierenden Reaktionsprodukte auf der Anodenfläche ablagern. Dadurch können die Elektronen mit fortschreitender Prozessdauer zunehmend schlechter abgeführt werden, bis ein vollständiger Verlust der Anode eintritt. Insbesondere tritt dieser Fall bei moderaten bis tiefen Prozesstemperaturen ein, z.B. für die Beschichtung von temperatursensitiven Substratmaterialien wie etwa 100Cr6 Stählen, in denen oftmals die Anodenwirkung einer Strahlungsheizung nicht genutzt werden kann, da diese während des Prozesses inaktiv ist. In diesem Fall kann die erfindungsgemäße bipolare Betriebsweise, mittels zweier oder mehrerer Arcverdampfer, ständig eine leitfähige Anodenfläche zur Elektronenabfuhr anbieten, da die Anodenfläche im Zeitintervall zuvor durch den kathodischen Betrieb "freigearct", also gesäubert, wurde. Deshalb ist die zeitliche Obergrenze für t₁ bis tₙ für den kathodischen, respektive anodischen, Betrieb durch jene Dauer begrenzt, welche die Ausbildung einer isolierenden Schicht auf der als Anode geschalteten Targetoberfläche zur Folge hat, welche nicht mehr durchschlag- bzw. zündfähig ist und somit eine erneute Zündung als materialliefernde Kathode ausschliesst.

Es kann jedoch auch vorkommen, dass Prozesseinstellungen gewählt werden müssen, welche die Bildung von isolierendem Material an der Kathodenoberfläche begünstigen, z.B. durch Verwendung spezieller Targetmaterialien. Die dadurch entstehende fortlaufende Targetvergiftung bedingt üblicherweise einen Anstieg der Brennspannung der Kathode, was schlussendlich durch die Stromversorgungsquelle nach oben hin begrenzt ist. In einem solchen Fall ist die zeitliche Obergrenze für t₁ bis tₙ für den kathodischen Betrieb durch das Erreichen der höchstzulässigen Brennspannung vorgegeben.

Die jeweils unteren bzw. oberen Grenzen für die Zeitintervalle t₁ bis tₙ sind demnach stark von den oben genannten Prozesseinflussgrößen abhängig und nicht zuletzt von der Art der zu beschichtenden Substrate, Beladungsdichte, sowie geometrischer Einflussfaktoren beeinflusst.

Bei dem erfindungsgemäßen Verfahren können für die Zündung des Lichtbogens an der Kathode neben oben erwähnten mechanischen Triggern, Triggerelektroden oder durch Laser auch noch andere Zündhilfen, wie z.B.: elektrische Primär- oder Sekundärquellen, wie u.a. durch Hochspannungszündung über Kondensator oder dergleichen, oder aber auch Zündung durch Nebenplasmen hervorgerufen durch Sputtern, und hierbei insbesondere HIPIMS, oder Plasmainjektion mittels z.B. einer Hohlkathode oder Ähnlichem, zum Einsatz kommen.

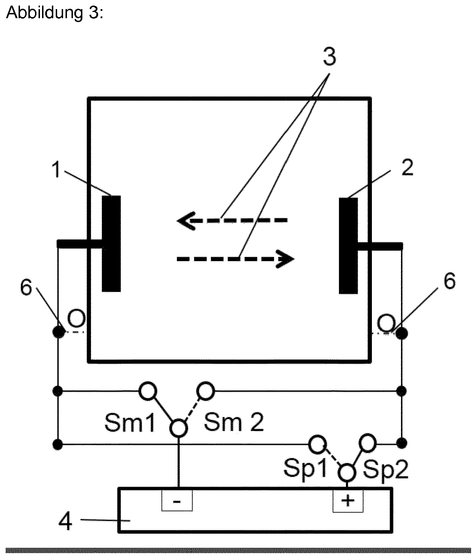

In Abbildung 3 ist schematisch eine einfache Lösung zur Umsetzung der bipolaren Betriebsweise mittels Umschaltung der Betriebsart der zumindest zwei Arcverdampfer 1 und 2 dargestellt. Die Umschaltung kann mittels Schutzschaltern, Halbleiterschaltern oder Ähnlichem realisiert werden. Wird ein Arcverdampfer 1 als materialliefernde Kathode geschalten, ist der Strompfad von der DC Stromversorgung 4, oder einer alternativen gepulsten DC-Stromversorgung, über Sm1 geschlossen und ein Arcverdampfer 2 als Anode über einen Schalter Sp2 mit der Stromquelle verbunden. Wird nun die Betriebsart eines Arcverdampfers von kathodisch zu anodisch, respektive für den korrespondierenden zweiten Arcverdampfer von anodisch zu kathodisch, gewechselt, erfolgt der Umschaltvorgang gleichzeitig an den angedeuteten Schaltelementen Sm bzw. Sp. Der Strompfad läuft demnach vom Minuspol der Stromversorgung 4 über den Schaltpfad Sm2 zum Arcverdampfer 2 (jetzt Kathode), wobei die Anbindung des Arcverdampfers 1 (jetzt Anode) mit dem Pluspol der Stromversorgung über den Schaltpfad Sp1 erfolgt.

Ein wechselweiser Betrieb der Arcverdampfer und somit ein erfindungsgemäßer bipolarer Arcverdampfungsprozess wird hiermit relativ einfach realisierbar.

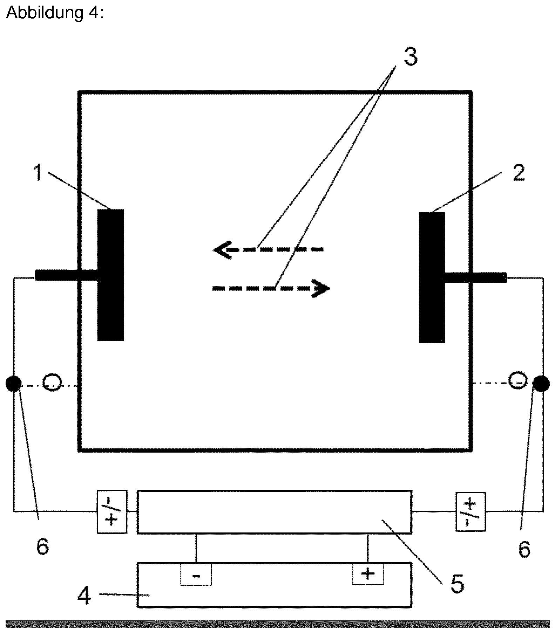

In einer besonderen Ausführungsform kann der Einsatz eines bipolaren Pulskonverters 5 der DC-Stromversorgung 4 während des Prozesses hinzugeschaltet werden. Diese Ausführungsform ist beispielhaft in Abbildung 4 skizziert. In dieser Anordnung ist es jedoch erforderlich, dass das Zünden der Verdampfer 1 oder 2 als Kathode entsprechend synchronisiert werden. Hierbei ist wichtig, dass das Umschalten der Arcverdampfer vom kathodischen zum anodischen Betrieb, bzw. als inaktiver Verdampfer, in geeigneten Zeitintervallen stattfindet.

In einer besonderen Ausführungsform ist eine Verbindung der Stromversorgung zur Kammer und/oder etwaigen Hilfsanoden, für die oben beschriebenen bipolaren Betriebsweisen möglich, was insbesondere zur Zündung der Kathode dienlich sein kann. Diese optionale Verbindung zur Kammer und/oder etwaigen Hilfsanoden 6 ist in den Abbildungen 1, 3, und 4 schematisch dargestellt und kann beispielsweise über geeignete Schalter, wie oben erwähnt, für ein kurzes Zeitintervall (z.B. als Zündhilfe) oder kontinuierlich über den jeweiligen Zeitraum t₁ bis tₙ erfolgen.

Es hat sich überraschend gezeigt, dass es für die vorliegende Erfindung von besonderem Vorteil ist, wenn die zumindest zwei verwendeten Arcverdampfer, welche in unterschiedlicher Betriebsweise geschaltet sind, möglichst nahe beieinander angeordnet sind. Die Arcverdampfer können daher beispielsweise unmittelbar nebeneinander angeordnet sein oder (auch) im Falle der Verwendung eines Reihenverdampfers mit mehreren Arcquellen auch übereinander. Es ist auch möglich, unterschiedliche Arcverdampfergeometrien, also etwa Rechteckverdampfer und kreisförmige und/oder zylinderförmige Verdampfer, miteinander in der oben beschriebenen Betriebsweise zu kombinieren.

Des Weiteren ist es ein besonders bevorzugtes Merkmal der gegenständlichen Erfindung, dass sich die verwendeten Targetmaterialien voneinander unterscheiden können. Hierdurch kann es durch geeignete Pulsintervalle sowohl zu einer homogenen Schichtausbildung an der Substratoberfläche kommen, als auch zur Ausbildung von Lagenstrukturen, u.a. bis hin zu einem Nanolayer-Vielschichtsystem.

Es wurde ein Arcverdampfungsverfahren zur Beschichtung von Oberflächen mittels eines Lichtbogens offenbart, wobei im Verfahren zumindest zwei aktive Verbrauchstargets eingesetzt werden, wobei während des Beschichtungsprozesses die Verbrauchstargets abwechselnd als Kathode und Anode geschaltet werden. Bei dem Verfahren können ein oder mehere Reaktivgase eingesetzt werden. Das zumindest eine Reaktivgas kann zumindest einen Bestandteil umfassen, welcher mit dem Targetmaterial eine elektrisch isolierende Verbindung eingeht. Die zumindest zwei unterschiedlichen Verbrauchstargets können sich in ihrer Zusammensetzung unterscheiden, wodurch es bei der Beschichtung zum Aufbau eines Nanolayer-Vielschichtsystems kommen kann. Die zumindest zwei aktiven Verbrauchstargets können in unmittelbarer Nachbarschaft angeordnet werden, dergestalt dass das sich über einem Target aufbauende Plasma, während dieses als Kathode betrieben wird, sich teilweise über das andere, zu diesem Zeitpunkt als Anode betriebenen Target überstreckt.

## Patentansprüche

1. Lichtbogenverdampfungsverfahren zur Beschichtung von Oberflächen, wobei die Stromversorgung der Kathode als unipolar gepulste DC Stromversorgung mit einem minimalen und einem maximalen Strom oder als Hochstrompulsung mit unterschiedlichen Amplituden erfolgt, wobei im Verfahren zumindest zwei aktive Verbrauchstargets eingesetzt werden, wobei während des Beschichtungsprozesses die Verbrauchstargets abwechselnd als Kathode und Anode geschaltet werden.

2. Verfahren nach Anspruch 1, **dadurch gekennzeichnet, dass** bei dem Verfahren zumindest ein Reaktivgas eingesetzt wird.

3. Verfahren nach Anspruch 2, **dadurch gekennzeichnet, dass** das zumindest eine Reaktivgas zumindest einen Bestandteil umfasst, welcher mit dem Targetmaterial eine elektrisch isolierende Verbindung eingeht.

4. Verfahren nach Anspruch 2 oder 3, **dadurch gekennzeichnet, dass** ein Gemisch aus einem oder mehreren Gasen verwendet wird, wobei zumindest ein Gas ein nichtreaktives Arbeitsgas ist.

5. Verfahren nach einem der vorangehenden Ansprüche, **dadurch gekennzeichnet, dass** die zumindest zwei unterschiedlichen Verbrauchstargets sich in ihrer Zusammensetzung unterscheiden, wodurch es bei der Beschichtung zum Aufbau eines Nanolayer-Vielschichtsystems kommt.

6. Verfahren nach einem der vorangehenden Ansprüche, **dadurch gekennzeichnet, dass** die zumindest zwei aktiven Verbrauchstargets in unmittelbarer Nachbarschaft angeordnet werden, dergestalt, dass das sich über einem Target aufbauende Plasma, während dieses als Kathode betrieben wird, sich teilweise über das andere, zu diesem Zeitpunkt als Anode betriebene Target überstreckt.

7. Verfahren nach einem der vorangehenden Ansprüche, **dadurch gekennzeichnet, dass** unterschiedlich lange Zeiträume t₁ bis tₙ für die jeweilige Betriebsart der zumindest zwei als Kathode bzw. Anode geschalteten Verbrauchstargets über die Gesamtbeschichtungszeit t_{ges} verwendet werden.

8. Verfahren nach Anspruch 7, **dadurch gekennzeichnet, dass** die unterschiedlich langen Zeiträume t₁ bis tₙ für die jeweilige Betriebsart der zumindest zwei als Kathode bzw. Anode geschalteten Verbrauchstargets in einer periodischen Abfolge über die Gesamtbeschichtungszeit t_{ges} verwendet werden.

9. Verfahren nach einem der vorhergehenden Ansprüche, **dadurch gekennzeichnet, dass** die zumindest zwei verwendeten Verbrauchstargets eine unterschiedliche Geometrie aufweisen.

10. Verfahren nach einem der vorhergehenden Ansprüche, **dadurch gekennzeichnet, dass** die Zündung des Lichtbogens durch Laser erfolgt.

## Claims

1. An electric-arc evaporation method for coating surfaces, wherein the current supply of the cathode takes place as a unipolar pulsed DC current supply with a minimum and a maximum current, or as a high-current pulsation with different amplitudes, wherein at least two active consumption targets are used in the method, wherein the consumption targets are alternately connected as a cathode and an anode during the coating process.

2. The method according to claim 1, **characterized in that** at least one reactive gas is used in the method.

3. The method according to claim 2, **characterized in that** the at least one reactive gas comprises at least one constituent forming an electrically insulating compound with the target material.

4. The method according to claim 2 or 3, **characterized in that** a mixture of one or several gases is used, wherein at least one gas is a non-reactive working gas.

5. The method according to any one of the preceding claims, **characterized in that** the at least two different consumption targets differ in their composition, wherein the buildup of a nanolayer multi-layer system occurs during coating.

6. The method according to any one of the preceding claims, **characterized in that** the at least two active consumption targets may be disposed directly adjacent in such a manner that the plasma forming over one target while the latter is operated as a cathode partially extends across the other target, which at that point in time is operated as an anode.

7. The method according to any one of the preceding claims, **characterized in that**, over the total coating time t_{ges}, periods t₁ to tₙ with different lengths are used for the respective mode of operation of the at least two consumption targets connected as a cathode or an anode.

8. The method according to claim 7, **characterized in that** the periods t₁ to tₙ with different lengths are used for the respective mode of operation of the at least two consumption targets connected as a cathode or an anode in a periodic sequence over the total coating time t_{ges}.

9. The method according to any one of the preceding claims, **characterized in that** the at least two consumption targets used have different geometries.

10. The method according to any one of the preceding claims, **characterized in that** the electric arc is ignited by laser.

## Revendications

1. Procédé d'évaporation à l'arc pour le revêtement de surfaces, l'alimentation en courant de la cathode s'effectuant sous forme d'alimentation en courant continu pulsée unipolaire avec un courant minimal et un courant maximal ou sous forme d'impulsion à courant fort avec des amplitudes différentes, au moins deux cibles consommables actives étant utilisées dans le procédé, les cibles consommables étant branchées alternativement comme cathode et comme anode pendant le processus de revêtement.

2. Procédé selon la revendication 1,
**caractérisé en ce que**
au moins un gaz réactif est utilisé dans le procédé.

3. Procédé selon la revendication 2,
**caractérisé en ce que**
ledit au moins un gaz réactif comprend au moins une composante qui établit une liaison électriquement isolante avec le matériau cible.

4. Procédé selon la revendication 2 ou 3,
**caractérisé en ce que**
on utilise un mélange d'un ou de plusieurs gaz, dont au moins un gaz est un gaz de travail non réactif.

5. Procédé selon l'une des revendications précédentes,
**caractérisé en ce que**
lesdites au moins deux cibles consommables différentes se distinguent de par leur composition, ce qui provoque la formation d'un système multicouche à nano-couches pendant le revêtement.

6. Procédé selon l'une des revendications précédentes,
**caractérisé en ce que**
lesdites au moins deux cibles consommables actives sont disposées à proximité immédiate de telle sorte que le plasma qui s'accumule au-dessus d'une cible pendant que celle-ci fait office de cathode, s'étend partiellement sur l'autre cible faisant office d'anode à cet instant.

7. Procédé selon l'une des revendications précédentes,
**caractérisé en ce que**
on utilise des durées de différentes longueurs t₁ à tₙ pour le mode de fonctionnement respectif desdites au moins deux cibles consommables branchées comme cathode ou comme anode sur la durée totale du revêtement tₜₒₜₐₗ.

8. Procédé selon la revendication 7,
**caractérisé en ce que**
les durées de différentes longueurs t₁ à tₙ pour le mode de fonctionnement respectif desdites au moins deux cibles consommables branchées comme cathode ou comme anode sont utilisées dans une succession périodique sur la durée totale du revêtement tₜₒₜₐₗ.

9. Procédé selon l'une des revendications précédentes,
**caractérisé en ce que**
lesdites au moins deux cibles consommables utilisées ont une géométrie différente.

10. Procédé selon l'une des revendications précédentes,
**caractérisé en ce que**
l'arc est amorcé par un laser.
